# EUROPEAN PATENT APPLICATION

(11) **EP 1 213 835 A1**
(43) Date of publication of application: **12.06.2002**
(21) Application number: 01124328.4
(22) Date of filing: 19.10.2001
(51) Int. Cl.: H03J 5/24

(54) **Filter circuit**

(30) Priority: 01.12.2000 JP 2000367354
(71) Applicant: Kabushiki Kaisha Toshiba, Tokyo 105-8001 (JP)
(72) Inventor: Iguchi, Kazutaka, Intellectual Property Division, Minato-ku, Tokyo 105-8001 (JP)
(74) Representative: HOFFMANN - EITLE

(57) **Abstract**

A filter circuit comprising a balanced filter system (2, 5, 5'), a non-balanced filter system (3, 6, 6'), and two switching units (7, 8). The balanced filter system (2, 5, 5') includes balanced filter-matching circuits (5, 5'), each composed of parallel elements. The non-balanced filter system (3, 6, 6') is connected to a voltage neutral point (A) defined by dividing the parallel elements of each of the balanced filter-matching circuits (5, 5') to halves. The switching units (7, 8) are provided at the input and output of the balanced filter system (2, 5, 5'), respectively, and switch the input and output of the balanced filter system (2, 5, 5'), each from a balanced state to a non-balanced state, and vice versa.

## Description

The present invention relates to a filter circuit, more particularly to a filter circuit having two filter systems that are to be connected in parallel between two balanced transmission circuits.

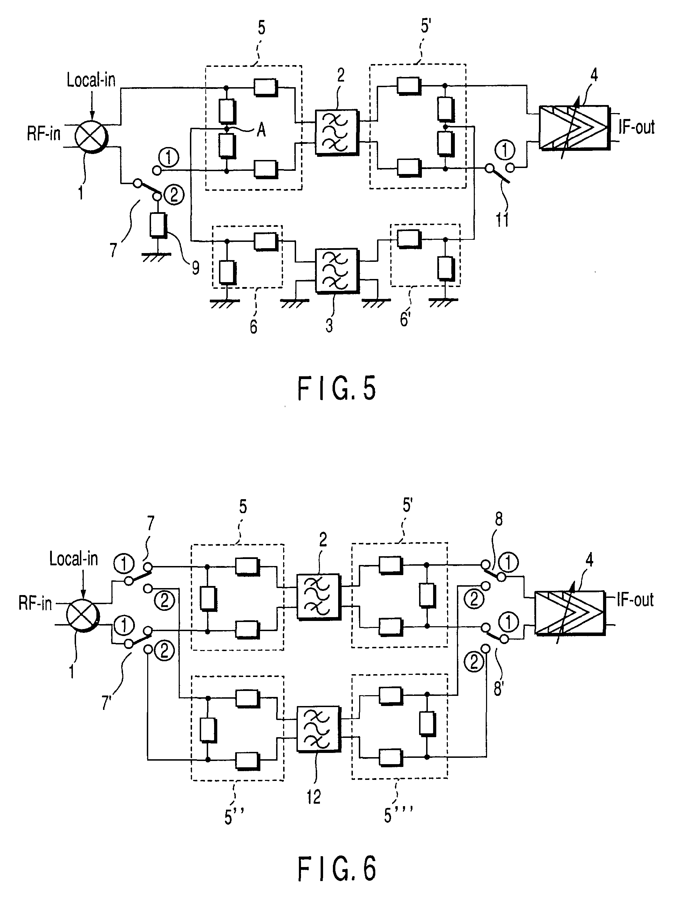

FIG. 6 shows a conventional filter circuit, which is a radio receiver IF circuit for use in mobile communication terminals. The radio receiver IF circuit can be used in two types of mobile communication terminals that are different in IF frequency or frequency band. The radio receiver IF circuit comprises two filters, one exhibiting characteristics desirable to the first-type communication terminal, and the other exhibiting characteristics desirable to the second-type communication terminal. More precisely, the IF circuit of FIG. 6 comprises a mixer 1, a first-system balanced IF filter 2, a second-system balanced IF filter 12, filter-input, two-contact switches 7 and 7', and filter-input, two-contact switches 8 and 8'. The first-system balanced IF filter 2 is designed for optimal use in the first-type mobile communication terminal. The second-system balanced IF filter 12 is designed for optimal use in the second-type mobile communication terminal. The mixer 1 converts the frequency of an input signal, generating a desirable IF signal having an intermediate frequency (IF). The IF signal, thus generated, is filtered by either the first-system balanced IF filter 2 or the second-system balanced IF filter 12. To select the IF filter 2 or IF filter 12, the two-contact switches 7. 7', 8 and 8' are operated. As FIG. 6 shows, the radio receiver IF circuit further comprises an IF gain-control amplifier 4 and balanced filter-matching circuits 5, 5', 5" and 5'".

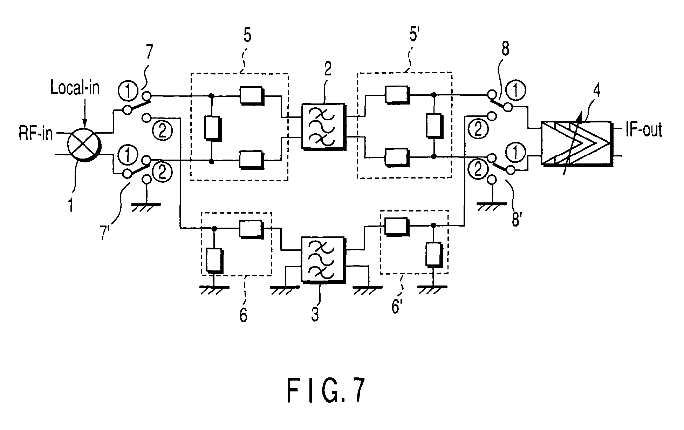

The radio receiver IF circuit of FIG. 6 has many branched lines, complicating the wring. To simplify the wiring, one of the two filter systems may be a non-balanced filter system as is illustrated in FIG. 7. More specifically, the non-balanced filter system comprises a second-system non-balanced IF filter 3 and non-balanced filter-matching circuits 6 and 6'. In this case, the number of wires connecting the mixer 1, IF filter 2, IF gain control amplifier 4 can be reduced by two. However, it is not desirable to keep one of the paired differential units connected to the first-system balanced IF filter 2 in order to operate the mixer 1 and IF gain-control amplifier 4 normally. In view of this, the switches 8 and 8' still need to be used. Consequently, the radio receiver IF circuit of FIG. 7 needs four two-contact switches, two at the input side and other two at the output side.

Thus, the conventional radio receiver IF circuit requires four two-contact switches. It is inevitably complex in structure. Further, it has many components and can hardly be made as small as is desired.

Accordingly, an object of the present invention is to provide a filter circuit which is simple in structure and comprises a small number of components and which can therefore be made small.

To attain the object, a filter circuit is provided according to the first aspect of the present invention. The filter circuit comprises: a balanced filter system including balanced filter-matching circuits, each composed of parallel elements; a non-balanced filter system connected to a voltage neutral point defined by dividing the parallel elements of each of the balanced filter-matching circuits to halves; and switching units provided at the input and output of the balanced filter system and configured to switch the input and output of the balanced filter system, each from a balanced state to a non-balanced state, and vice versa.

According to the second aspect of the invention there is provided a filter circuit that is similar to the circuit according to the first aspect. In this filter circuit, the switching units include two-contact switches provided at the input and output of the balanced filter system, respectively. Each of the two-contact switches has one contact connected to one of paired input/output differential units of the balanced filter system and the other contact connected to the ground.

According to the third aspect of the invention there is provided a filter circuit that is similar to the circuit according to the first aspect. In the filter circuit according to the third aspect, the switching units include one-contact switches provided at the input and output of the balanced filter system, respectively. Each of the switches has one contact to be connected to or disconnected from one of paired input/output differential units of the balanced filter system.

According to the fourth aspect of the invention there is provided a filter circuit that is similar to the circuit according to the first aspect. In this filter circuit, the switching units include two-contact switches provided at the input and output of the balanced filter system, respectively. Each of the two-contact switches has one contact connected to one of paired input/output differential units of the balanced filter system and the other contact connected to one end of a reactor element, which in turn is connected to the ground.

According to the fifth aspect of the invention there is provided a filter circuit that is similar to the circuit according to the first aspect. In this filter circuit, the switching units include a one-contact switch and a two-contact switch. The one-contact switch is provided at the input of the balanced filter system and can be connected to or disconnected from one of paired input/output differential units of the balanced filter system. The two-contact switch is provided at the output of the balanced filter system. It has one contact connected to one of paired input/output differential units of the balanced filter system and the other contact connected to a reactor element, which in turn is connected to the ground.

According to the sixth aspect of the invention there is provided a filter circuit that is similar to the circuit according to the first aspect. In this filter circuit, the switching units include a two-contact switch and a one-contact switch. The two-contact switch is provided at the input of the balanced filter system. It has one contact connected to one of paired input/output differential units of the balanced filter system and the other contact connected to a reactor element, which in turn is connected to the ground. The one-contact switch is provided at the output of the balanced filter system and can be connected to or disconnected from one of paired input/output differential units of the balanced filter system.

This summary of the invention does not necessarily describe all necessary features so that the invention may also be a sub-combination of these described features.

The invention can be more fully under stood from the following detailed description when taken in conjunction with the accompanying drawings, in which:
FIG. 1 is a diagram showing the first embodiment of the present invention;
FIG. 2 is a diagram illustrating the second embodiment of the invention;
FIG. 3 is a diagram depicting the third embodiment of this invention;
FIG. 4 is a diagram illustrating the fourth embodiment of the present invention;
FIG. 5 is a diagram showing the fifth embodiment of the invention;
FIG. 6 is a diagram depicting a conventional filter circuit; and
FIG. 7 is a diagram illustrating another type of a conventional filter circuit.

A filter circuit according to the present invention will be briefly described. In the filter circuit, the parallel element incorporated in a balanced filter matching circuit (hereinafter referred to as "first system") is divided into equal halves, defining a voltage neutral point, and the input and output of a non-balanced filter (hereinafter referred to as "second system" are connected to the voltage neutral point. This reduces the number of switches required in the conventional filter circuit. While the first-system is operating, the second system remains connected to a balanced transmission neutral point. Therefore, the operating characteristic of the second system scarcely influences the operating characteristic of the first system. When the switches provided at a filter system impair the balanced state, changing the state to an unbalanced one, the neutral point at the input of the first system is switched to the driving point of the second system, and the neutral point at the output of the first system is switched to the load point of the second system. That is, the first system can be switched to the second system by operating only the switches that impair the balanced state. Only two switches should be provided at the input and output of the second system. Namely, only two switches are required, whereas four switches must be used in the conventional filter circuit. Thus, the filter circuit of the present invention is simpler than the conventional filter circuit, because it comprises fewer components.

As indicated above, the input and output of the non-balanced filter are connected to the voltage neutral point defined by dividing the parallel element of the balanced filter matching circuit into equal halves. The filter circuit of this invention therefore needs but less switches than the conventional filter circuit. Hence, the invention can provide a radio receiver IF circuit that is simple in structure and comprises a relatively small number of components.

Various embodiments of the present invention will be described, with reference to the accompanying drawings.

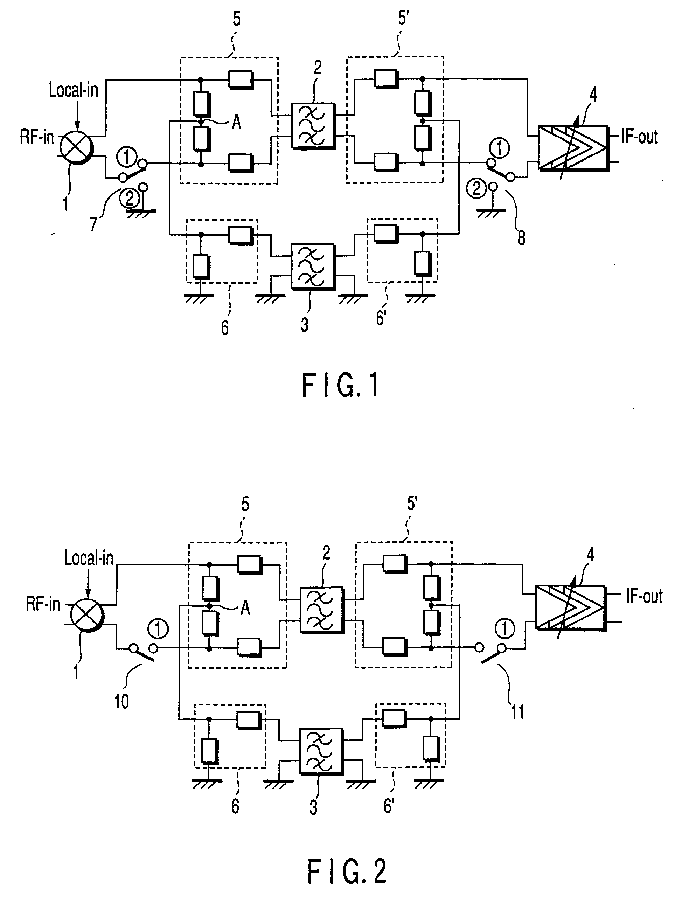

FIG. 1 shows the first embodiment of the present invention. As shown in FIG. 1, the first embodiment, which is a filter circuit, comprises a mixer 1, a first-system balanced IF filter 2, a second-system non-balanced IF filter 3, an IF gain-control amplifier 4, balanced filter-matching circuits 5 and 5', non-balanced filter-matching circuits 6 and 6', a filter-input, two-contact switch 7, and a filter-output, two-contact switch 8. The balanced filter-matching circuits 5 and 5' and the first-system balanced IF filter 2 constitute a balanced filter system. The non-balanced filter-matching circuits 6 and 6' and the second-system non-balanced IF filter 3 constitute a non-balanced filter system.

In the filter circuit of FIG. 1, the movable contacts of the two-contact switches 7 and 8 are connected to contacts 1 in order to operate the first system. Since the input and output of the second-system IF filter are connected to a neutral point A of balanced transmission voltage, the operating characteristics of the second system influences those of the first system, but very little. To operate the second system, the movable contacts of the two-contact switches 7 and 8 are connected to contacts 2. As a result, the balanced input state of the first system becomes a non-balanced state. The neutral point at the input of the first system is therefore switched to the driving point of the second system, and the neutral point at the output of the first system is switched to the load point of the second system.

Since the non-balanced filter-matching circuits 6 and 6' are tuned to this condition, the characteristics of the second system are predominant. At the same time the balanced input state of the first system is impaired, the balanced filter-matching circuits 5 and 5' are de-tuned, the operating characteristics of the fist system influences those of the second system, but very little.

FIG. 2 illustrates the second embodiment of the invention, which is a filter circuit. The second embodiment is identical to the first embodiment, except that the stationary contacts 2 of the two-contact switches 7 and 8 remain open at all times. In other words, one-contact switches 10 and 11 replace the switches 7 and 8 in the second embodiment. Obviously, one-contact switches are simpler than two-contact switches. The second embodiment can therefore be made smaller than the first embodiment.

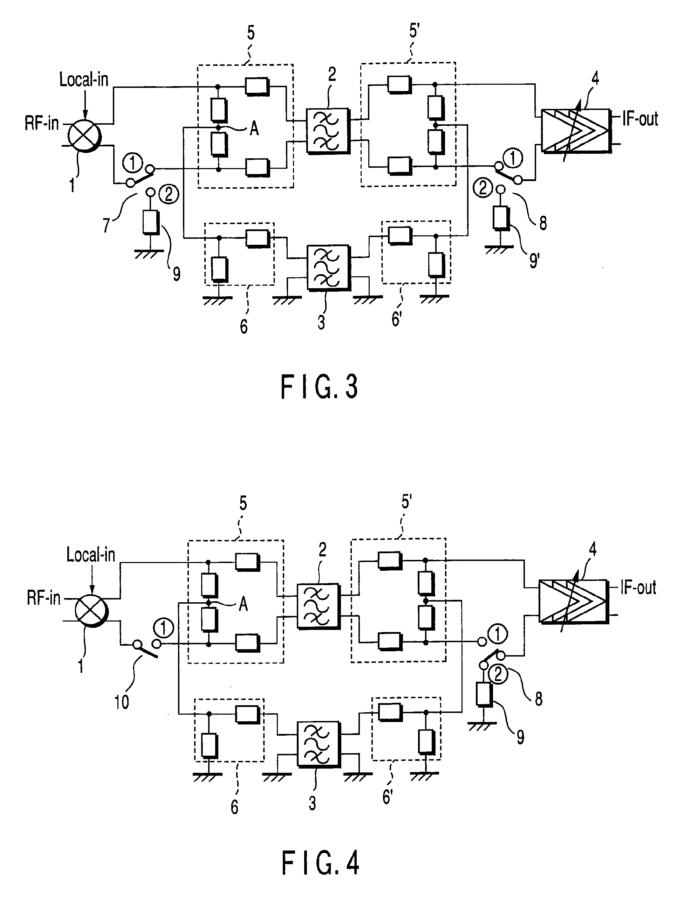

FIG. 3 depicts the third embodiment of the invention, which is a filter circuit, too. The third embodiment is identical to the first embodiment, except for two points. First, a reactor element 9 is connected between the filter-input, two-contact switch 7 and the ground. Second, a reactor element 9' is connected between the filter-output, two-contact switch 8 and the ground. So far as the operation of the second system is concerned, the third embodiment is identical to the first and second embodiments. Note that the reactor elements 9 and 9' have such a reactance as will cause the second system to operate in the most desirable manner.

To make the second system operate in the most desirable manner, the stationary contacts 2 of either two-point switch may assume various states. FIG. 4 shows the fourth embodiment of the invention. In the fourth embodiment, the stationary contact 2 of the filter-input, two-contact switch 7 is opened. In other words, a one-contact switch 10 replaces the switch 7 and a reactance element 9 is connected between the contact 2 of the filter-output, two-contact switch 8 and the ground.

FIG. 5 illustrates the fifth embodiment of the invention. As FIG. 5 shows, the stationary contact 2 of the filter-output, two-contact switch 8 is opened. In other words, a one-contact switch 11 replaces the switch 8 and a reactance element 9 is connected between the contact 2 of the filter-input, two-contact switch 7 and the ground.

The first to fifth embodiments described above need to have, but less switches than is required in the conventional dual-mode, radio receiver IF circuit. Thus, the present invention makes it possible to provide a ratio receiver IF circuit that can be made small because it has a simple structure and comprises a small number of components.

Hence, the present invention can provide a filter circuit that has a simple structure, comprises a small number of components and can therefore be made small.

## Claims

1. A filter circuit **characterized by** comprising:
a balanced filter system (2, 5, 5') including balanced filter-matching circuits (5, 5'), each composed of parallel elements;
a non-balanced filter system (3, 6, 6') connected to a voltage neutral point (A) defined by dividing the parallel elements of each of the balanced filter-matching circuits (5, 5') to halves; and
switching units provided at the input and output of the balanced filter system (2, 5, 5') and configured to switch the input and output of the balanced filter system (2, 5, 5'), each from a balanced state to a non-balanced state, and vice versa.

2. The filter circuit according to claim 1, **characterized in that** the switching units include two-contact switches (7, 8) provided at the input and output of the balanced filter system (2, 5, 5'), respectively, and each of the two-contact switches has one contact connected to one of paired input/output differential units of the balanced filter system and the other contact connected to the ground.

3. The filter circuit according to claim 1, **characterized in that** the switching units include one-contact switches (10, 11) provided at the input and output of the balanced filter system, respectively, each of the one-contact switches (10, 11) has one contact to be connected to or disconnected from one of paired input/output differential units of the balanced filter system.

4. The filter circuit according to claim 1, **characterized in that** the switching units include two-contact switches (7, 8) provided at the input and output of the balanced filter system (2, 5, 5'), respectively, each of the two-contact switches (7, 8) has one contact connected to one of paired input/output differential units of the balanced filter system (2, 5, 5') and the other contact connected to a reactor element (9), which in turn connected to the ground.

5. The filter circuit according to claim 1, **characterized in that** the switching units include a one-contact switch (10) provided at the input of the balanced filter system (2, 5, 5') and configured to be connected to or disconnected from one of paired input/output differential units of the balanced filter system (2, 5, 5'), and a two-contact switch (8) provided at the output of the balanced filter system (2, 5, 5') and having one contact connected to one of paired input/output differential units of the balanced filter system (2, 5, 5') and the other contact connected to a reactor element (9), which in turn is connected to the ground.

6. The filter circuit according to claim 1, **characterized in that** the switching units include a two-contact switch (7) provided at the input of the balanced filter system (2, 5, 5') and having one contact connected to one of paired input/output differential units of the balanced filter system (2, 5, 5') and the other contact connected to a reactor element (9), which in turn is connected to the ground, and a one-contact switch (111) provided at the output of the balanced filter system (2, 5, 5') and configured to be connected to or disconnected from one of paired input/output differential units of the balanced filter system (2, 5, 5').
